(19) **Europäisches Patentamt**

**European Patent Office**

**Office européen des brevets**

(11) **EP 0 979 553 B1**

(12) **EUROPEAN PATENT SPECIFICATION**

| | |
|---|---|
| (45) Date of publication and mention of the grant of the patent: **08.10.2003 Bulletin 2003/41** | (51) Int Cl.$^7$: **H03G 3/20** |
| (21) Application number: **98901455.0** | (86) International application number: **PCT/IB98/00191** |
| (22) Date of filing: **16.02.1998** | (87) International publication number: **WO 98/038735 (03.09.1998 Gazette 1998/35)** |

(54) **SIGNAL PROCESSING DEVICE**

SIGNALVERARBEITUNGSVORRICHTUNG

DISPOSITIF DE TRAITEMENT DU SIGNAL

(84) Designated Contracting States:
**DE ES FR GB IT**

(30) Priority: **26.02.1997 EP 97200544**

(43) Date of publication of application:
**16.02.2000 Bulletin 2000/07**

(73) Proprietor: **Koninklijke Philips Electronics N.V.
5621 BA Eindhoven (NL)**

(72) Inventor: **VAN GESTEL, Henricus, Antonius, Wilhelmus
NL-5656 AA Eindhoven (NL)**

(74) Representative:
**Groenendaal, Antonius Wilhelmus Maria
Philips
Intellectual Property & Standards
P.O. Box 220
5600 AE Eindhoven (NL)**

(56) References cited:
**US-A- 5 046 107          US-A- 5 303 371**

• **PATENT ABSTRACTS OF JAPAN; & JP,A,07 222 078 (SONY CORP) 18 August 1995.**
• **PATENT ABSTRACTS OF JAPAN; & JP,A,09 037 174 (MATSUSHITA ELECTRIC IND CO LTD) 7 February 1997.**
• **PATENT ABSTRACTS OF JAPAN, Vol. 17, No. 511, (E-1432); & JP,A,05 130 674 (SONY CORP) 25 May 1993.**

## Description

The invention relates to a signal processing device comprising:

- a signal source selection means for selecting a signal source from a set of at least two signal sources, the signal from each of the signal sources having at least one controllable parameter, whose value W is defined by a global value G and a local value L associated with a selected signal source,
- a control for adjusting the value W,
- a storage register for the storage of the global value G,
- for each signal source a storage register for the storage of the local value L,
- means for obtaining the resultant value W by means of a predetermined combination of G and L.

Such a signal processing device is known from US-A-5 046 107. In the known device the controllable parameter referred to each time is the signal strength of the audio signal and the local value is an offset with respect to the global setting of the signal strength. In a given embodiment the known device comprise a separate control for adjusting the local values associated with the selected signal source. This control enables mutual differences in signal volume among the various signal sources to be compensated for. This has the drawback that an additional control element is required and that for each volume correction the user is expected to decide how the correction should be divided between the global volume and the offset value. If the user decides that both values should be corrected, two actions are required.

In another embodiment the known device does not have a separate control for the offset value associated with the selected signal source but the offset value is determined by the master volume control. However, it is not clear how and under what conditions a correction of the master volume control causes a change in the offset value.

It is an object of the invention to provide a signal processing device and a method of the types defined in the opening paragraphs, which automatically compensate for differences in signal parameters, such as for example volume of sound and picture contrast of a TV signal, between the various signal sources.

To this end, the device.in accordance with the invention is characterized in that the device further comprises:

- detection means for determining whether a change $\delta W$ of W occurs, induced by a change of the setting of the control, within a predetermined time interval $\Delta T$ after selection of a signal source,
- means adapted to change L by an amount $\delta L$ and G by an amount $\delta G$ if $\delta W$ occurs within $\Delta T$.

As a result of these measures, parameter adaptations within a given time interval after changing over from one signal source to another are interpreted as an intention to adapt, in addition to the global parameter value, also the local value for the signal source just selected to a given extent. Depending on the degree of change in the local values differences with respect to other signal sources will be compensated for automatically after a given signal source has been selected at least 1 time. After said time interval the local value is no longer adapted and parameter adaptations are regarded as corrections of the global setting, for example in order to allow for changing ambient conditions, a changing mood of the user, or changing signal properties.

A further advantage of the invention is the absence of an additional control for setting local values, as a result of which the device can be cheaper and more compact.

The invention is very suited for use in radio and television receivers for the automatic compensation of differences in volume of sound among radio stations and television stations, respectively. The invention can also be used in amplifiers for automatic control of the input sensitivities. Moreover, the invention can be utilized for other parameters than volume, for example brightness, contrast or equalizer settings.

These and other aspects of the invention will be described in more detail with reference to an embodiment given by way of example.

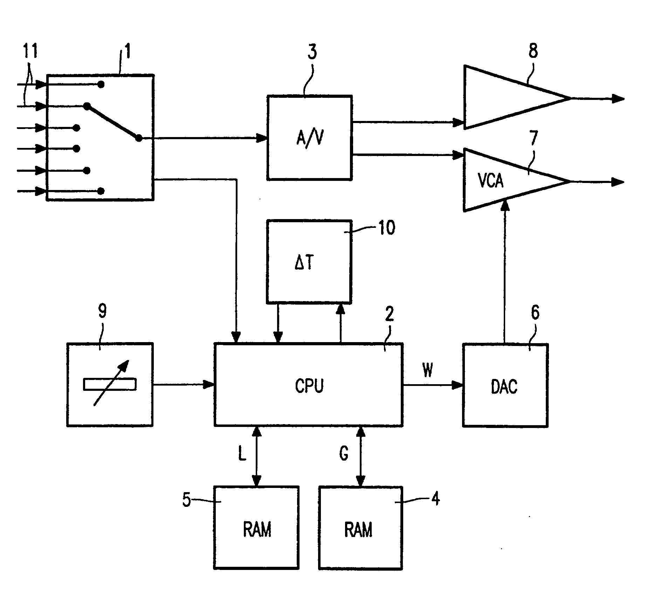

The Figure shows a diagram of a television receiver as an example of a signal processing device in accordance with the invention.

The television receiver shown in the Figure comprises as signal source selection means a channel selector 1, known per se, which has a plurality of preselection positions (presets). A TV channel 11 of a set of TV channels can be assigned to each preset, so that this channel is rapidly accessible via a touch control or numerical index corresponding to the relevant preset. The channel selector 1 can transfer a selected TV signal to an input of an audio/video splitter 3. The audio/video splitter 3 has a video output connected to a video input of a video amplifier 8 and has an audio output connected to an audio input of a voltage-controlled audio amplifier (VCA) 7. The device further comprises a CPU 2 arranged to receive information from the channel selector 1, a control 9, a first storage register 4, a plurality of second storage registers 5 and a timer 10. The CPU 2 can supply information to the first storage register 4, the second storage registers 5, the timer 10 and a digital-to-analog converter (DAC) 6. The number of second storage registers 5 is equal to the number of presets. The DAC 6 has its output connected to the control input of the VCA 7.

The channel selector 1 is controlled by the user to select a TV channel. After a selection the channel selector 1 informs the CPU 2 which preset has been selected. Moreover, the channel selector 1 transfers the TV signal to the audio/video splitter 3. The extracted audio signal is transferred to the VCA 7 and the extracted video signal is transferred to the video amplifier 8. One of the second storage registers 5 is associated with each preset to store a local value L of the sound volume. After selection of a preset the CPU 2 fetches a global value G of the volume from the first storage register 4 and the local value L of the relevant preset from the second storage register 5. The domains of L and G may differ from one another. For example, 4 bits may be reserved for L and 6 bits for G, resulting in domains of 16 and 64 values, respectively. The CPU 2 combines these two values, for example by addition, so as to form a resultant value W, which is transferred to the DAC 6. The DAC converts the digital value into an analog control signal which is employed to determine the gain factor of the VCA 7 so as to obtain a resultant value for the volume of sound.

After channel selection the CPU 2 also supplies a start signal to the timer 10, which assumes another state, identifiable by the CPU 2, for a given time interval $\Delta T$. The length of the time interval $\Delta T$ can have a predetermined constant value but can alternatively be dependent in a predetermined manner on conditions before or during $\Delta T$.

If the user corrects the setting of the control 9 before or after this time interval the CPU 2 only changes the global value G of the volume in the first storage register 4, combines the new value G with the local value L from the second storage register 5, and transfers the resultant value W to the DAC 6, after which the volume is changed as described.

If the user makes the correction within the time interval $\Delta T$, the CPU 2 changes the global value G of the volume in the first storage register 4 by a predetermined amount $\delta G$, it changes the local value L of the selected preset in the second storage register 5 by a predetermined amount $\delta L$, and it combines the new values of G and L to adapt the volume as described.

Thus, volume corrections immediately after selection of a channel affect the local value associated with the selected channel. These corrections are regarded as intentions to compensate for a difference in volume with the last selected channel. By dividing the correction between the global value and the local value it is achieved that the volume requires a smaller correction upon a subsequent selection of the relevant channel. The user need not be aware of this process. No separate action is required to set the local values and, consequently, not a special control element.

The change $\delta G$ in the global value can be zero. In that case a volume correction is wholly allocated to the local value. Thus, mutual differences in volume are canceled at once, while the global volume setting is not affected. The latter ensures that the user need not readjust the volume when a following channel is selected. This advantage can also be achieved by allowing $\delta G$ to be non-zero but canceling this change upon selection of a subsequent channel. The volume correction is now included only partly in the local value, so that this value is adapted more gradually.

With these embodiments the problem may arise that the user also or merely intended to adjust the global volume. Upon selection of a following channel it will then appear that this adjustment has not been made. This problem can be mitigated by making the length of the time interval $\Delta T$ not too large. Indeed, as the time goes by the likelihood increases that a volume correction is intended to adapt the global level because certain conditions such as the ambient noise, the state of mind of the user, or the nature of the audio signal change. To give the user ample opportunity to come to an optimum adjustment in spite of this, the length of $\Delta T$ could be made dependent on conditions before or during $\Delta T$. The initial length of $\Delta T$ could be dependent on, for example, the rate at which prior operating actions succeed one another or on the detected difference between the local values of the current channel and the preceding channel. Moreover, $\Delta T$ could be incremented by a given amount after each correction, while the increment could depend on the frequency and/or the amplitude of the applied corrections.

There are different ways of combining the global value G and the local value L to the resultant value W. In the present embodiment W is the sum of G and L, resultant values for W which exceed the domain of W being mapped on the exceeded domain limit. This check can be dispensed with if the domains of W, G and L are selected in such a manner that exceeding is not possible. If a correction $\delta W$ occurs within the time interval $\Delta T$, there are different ways of determining $\delta G$ and $\delta L$. Some possibilities are:

- $\delta L = \delta W / N$, $\delta G = \delta W * (N-1) / N$. Here the correction is divided between $\delta G$ and $\delta L$ in a constant ratio, so that the local value is adapted only gradually.
- $\delta L = (\delta W + 1) / 3$. Here, the ratio between $\delta L$ and $\delta G$ is no longer constant. For small corrections $\delta W$ the value $\delta L$ is comparatively large, whereas for large corrections $\delta L$ is comparatively small.
- $\delta L$ is a function of $\delta W$ in the following manner:

  - if $\delta W >= 2$ then $\delta L = 1$
  - if $\delta W <= -2$ then $\delta L = -1$
  - if $\delta W > -2$ and $\delta W < 2$ then $\delta L = 0$
    This algorithm allows only small steps $\delta L$, as a result of which the local values are reached only after the relevant channel has been selected a number of times. Conversely, the risk of overshooting or misinterpretation is comparatively small.

In another embodiment W is the product of G and L. An advantage of this is that for any value of G a local value L equal to zero yields a resultant value W equal to zero. As a result of this, the volume of sound of a channel can be reduced to zero in an absolute sense. Another advantage is that problems with domain limits can be precluded simply, for example, by making G and L equal to one another and making the domain of G range from 0 to 1.

The manner in which δL is determined as a function of δW can also depend on the instant t at which the correction δW is applied, starting from the beginning of the time interval ΔT. Examples of such functions are:

$$\delta L = \delta W - (\delta W / \Delta T) * t$$

and:

$$\delta L = \delta W * (\cos(180 * t / \Delta T ) + 1) / 2$$

Here, δL is substantially equal to δW if δW starts immediately after selection of another channel. The effect on the local value decreases and the effect on the global value increases as it takes longer before the correction δW is applied. This corresponds to the intuition that immediately after changing over a user is most aware of a difference in volume with the preceding channel and a volume correction is likely to be intended in order to achieve a permanent compensation for this difference. After this, it becomes more likely that other factors change, such as the ambient noise, the state of mind of the user, or the nature of the audio signal itself. As a result, it also becomes more likely that a volume correction is intended to adapt the global level.

In addition to the audio volume, it is likewise possible to adjust other parameters automatically for each signal source, such as brightness, contrast or equalizer setting. Each parameter requires the addition of:

1. a control
2. a storage register for the global value
3. storage registers for the local value for each signal source
4. a device for effecting the parameter adjustment.

For each of the embodiments described hereinbefore reference has been made to parameter corrections initiated by the user by means of a control which can be operated. However, the control may alteratively comprise an automatic circuit which can initiate the parameter corrections autonomously. Such a control could, for example, reduce the volume of sound when it exceeds a given maximum value, or it could measure the difference in volume between two channels and apply a volume correction on the basis of this difference.

Summarizingly, the invention relates to a signal processing device which comprises a signal source selection means (1), such as a channel selector in a television receiver or a source selection circuit in an amplifier, differences in signal parameters, such as for example volume of sound or picture brightness, between the signal sources (11) being compensated automatically. For this purpose the invention utilizes corrections which are applied to the relevant parameter within a given time interval after the source selection. These corrections are divided within said time interval between the global value and a local value (for example an offset) for the relevant signal source.

## Claims

1. A signal processing device comprising:

   - a signal source selection means for selecting a signal source from a set of at least two signal sources, the signal from each of the signal sources having at least one controllable parameter, whose value W is defined by a global value G and a local value L associated with a selected signal source,
   - a control for adjusting the value W,
   - a storage register for the storage of the global value G,
   - for each signal source a storage register for the storage of the local value L,
   - means for obtaining the resultant value W by means of a predetermined combination of G and L,

   **characterized in that** the device further comprises:

   - detection means for determining whether a change δW of W occurs, induced by a change of the setting of the control, within a predetermined time interval ΔT after selection of a signal source,
   - means adapted to change L by an amount δL and G by an amount δG if δW occurs within ΔT.

2. A signal processing device as claimed in Claim 1, **characterized in that** δG is substantially 0.

3. A signal processing device as claimed in Claim 1, **characterized in that** the device also comprises means for canceling the change δG upon selection of another signal source.

4. A signal processing device as claimed in Claim 1, **characterized in that** W is substantially equal to the sum of L and G.

5. A signal processing device as claimed in Claim 1, **characterized in that** W is substantially equal to the product of L and G.

6. A signal processing device as claimed in Claim 1, **characterized in that** said changes δL and δG are functions of the instant at which the change δW is induced, starting from the beginning of ΔT.

7. A signal processing device as claimed in Claim 1, **characterized in that** the device also comprises means for adjusting the length of the time interval ΔT in dependence upon predetermined conditions before or during ΔT.

8. A television receiver including a channel selector signal processing device as claimed in any one of the Claims 1 through 7, the signal source selection means being a channel selector.

9. A method of processing signals, comprising

  - the selection of a signal source from a set of at least two signal sources, the signal from each of the signal sources having at least one controllable parameter, whose value W is defined by a global value G and a local value L associated with a selected signal source,
  - the adjustment of the value W,
  - the storage of the global value G,
  - the storage, for each signal source, of the associated local value L,
  - the determination of the resultant value W by means of a predetermined combination of G and L,

  **characterized in that** the method further comprises:

  - the detection whether the adjustment of the value W occurs within a predetermined time interval ΔT after selection of a signal source,
  - the change of L by an amount δL and the change of G by an amount δG if δW occurs within ΔT.

10. A method as claimed in Claim 9, **characterized in that** δG is substantially 0.

11. A method as claimed in Claim 9, **characterized in that** the change δG is canceled upon selection of another signal source.

12. A method as claimed in Claim 9, **characterized in that** W is substantially equal to the sum of L and G.

13. A method as claimed in Claim 9, **characterized in that** W is substantially equal to the product of L and G.

14. A method as claimed in Claim 9, **characterized in that** said changes δL and δG are functions of the instant at which the change δW is induced, starting from the beginning of ΔT.

15. A method as claimed in Claim 9, **characterized in that** the method also comprises the adjustment of the length of the time interval ΔT in dependence upon predetermined conditions before or during ΔT.

16. A method as claimed in any one of the Claims 9 through 15, **characterized in that** the method comprises the selection of channels in a television receiver.

**Patentansprüche**

1. Signalverarbeitungsanordnung, das die nachfolgenden Elemente umfasst:

  - Signalquellenselektionsmittel zum Selektieren einer Signalquelle aus einem Satz von wenigstens zwei Signalquellen, wobei das Signal jeder der Signalquellen wenigstens einen steuerbaren Parameter hat, dessen Wert W durch einen globalen Wert G und einen lokalen Wert L, der mit einer selektierten Signalquelle assoziiert ist, definiert wird,
  - eine Steuerung zum Einstellen des Wertes W,
  - ein Speicherregister zur Speicherung des globalen Wertes G,
  - für jede Signalquelle ein Speicherregister zur Speicherung des lokalen Wertes L,
  - Mittel zum Erhalten des resultierenden Wertes W mit Hilfe einer vorbestimmten Kombination von G und L,

  **dadurch gekennzeichnet, dass** die Anordnung weiterhin die nachfolgenden Elemente umfasst:

  - Detektionsmittel um zu ermitteln, ob eine Änderung δW oder W auftritt, induziert durch eine Änderung der Einstellung der Regelung, innerhalb eines vorbestimmten Zseitintervalls ΔT nach der Selektion einer Signalquelle,
  - Mittel zum Ändern von L um einen Betrag δL und von G um einen Betrag δG, wenn δW innerhalb von ΔT auftritt.

2. Signalverarbeitungsanordnung nach Anspruch 1, **dadurch gekennzeichnet, dass** δG im Wesentlichen 0 ist.

3. Signalverarbeitungsanordnung nach Anspruch 1, **dadurch gekennzeichnet, dass** die Anordnung ebenfalls Mittel aufweist zum Rückgängigmachen der Änderung δG bei Selektion einer anderen Signalquelle.

4. Signalverarbeitungsanordnung nach Anspruch 1, **dadurch gekennzeichnet, dass** W im Wesentlichen der Summe von L und G entspricht.

5. Signalverarbeitungsanordnung nach Anspruch 1, **dadurch gekennzeichnet, dass** W im Wesentlichen dem Produkt aus L und G entspricht.

6. Signalverarbeitungsanordnung nach Anspruch 1, **dadurch gekennzeichnet, dass** die genannten Änderungen δL und δG Funktionen des Zeitpunktes sind, wo die Änderung δW induziert wird, ausgehend von dem Anfang von ΔT.

7. Signalverarbeitungsanordnung nach Anspruch 1, **dadurch gekennzeichnet, dass** die Anordnung ebenfalls Mittel aufweist zum Einstellen der Länge des Zeitintervalls ΔT in Abhängigkeit von vorbestimmten Bedingungen vor oder während ΔT.

8. Fernsehempfänger mit einer Kanalwählersignalverarbeitungsanordnung nach einem der Ansprüche 1 bis 7, wobei die Signalquellenselektionsmittel ein Kanalwähler sind.

9. Verfahren zum Verarbeiten von Signalen, wobei dieses Verfahren die nachfolgenden Verfahrensschritte umfasst:

   - das Selektieren einer Signalquelle aus einem Satz von wenigstens zwei Signalquellen, wobei das Signal von jeder der Signalquellen wenigstens einen steuerbaren Parameter hat, dessen Wert W durch einen globalen Wert G und einen lokalen Wert L, der mit einer selektierten Signalquelle assoziiert ist, definiert wird,
   - das Einstellen des Wertes W,
   - das Speichern des globalen Wertes G,
   - das für jede Signalquelle Speichern des zugeordneten lokalen Wertes L,
   - das Ermitteln des resultierenden Wertes W mit Hilfe einer vorbestimmten Kombination von G und L,

   **dadurch gekennzeichnet, dass** das Verfahren weiterhin die nachfolgenden Verfahrensschritte umfasst:

   - das Detektieren, ob die Einstellung des Wertes W innerhalb eines vorbestimmten Zeitintervalls ΔT nach der Selektion einer Signalquelle auftritt,
   - das Ändern von L um einen Betrag δL und das Ändern von G um einen Betrag δG, wenn δW innerhalb von ΔT auftritt.

10. Verfahren nach Anspruch 9, **dadurch gekennzeichnet, dass** δG im Wesentlichen 0 ist.

11. Verfahren nach Anspruch 9, **dadurch gekennzeichnet, dass** die Änderung δG bei Selektion einer anderen Signalquelle rückgängig gemacht wird.

12. Verfahren nach Anspruch 9, **dadurch gekennzeichnet, dass** W im Wesentlichen der Summe von L und G entspricht.

13. Verfahren nach Anspruch 9, **dadurch gekennzeichnet, dass** W im Wesentlichen dem Produkt aus L und G entspricht.

14. Verfahren nach Anspruch 9, **dadurch gekennzeichnet, dass** die genannten Änderungen δL und δG Funktionen des Zeitpunktes sind, an dem die Änderung δW induziert wird, ausgehend von dem Anfang von ΔT.

15. Verfahren nach Anspruch 9, **dadurch gekennzeichnet, dass** das Verfahren ebenfalls die Einstellung der Länge des Zeitintervalls ΔT in Abhängigkeit von vorbestimmten Bedingungen vor oder Während ΔT umfasst.

16. Verfahren nach einem der Ansprüche 9 bis 15, **dadurch gekennzeichnet, dass** das Verfahren das Wählen von Kanälen in einem Fernsehempfänger umfasst.

**Revendications**

1. Dispositif de traitement de signal, comportant

   - des moyens de sélection de source de signaux pour sélectionner une source de signaux dans un jeu d'au moins deux sources de signaux, le signal provenant de chacune des sources de signaux présentant au moins un paramètre pouvant être commandé, dont la valeur W est définie par une valeur globale G et une valeur locale L associées à une source de signaux sélectionnée;
   - une commande pour régler la valeur W;
   - un registre de mémoire pour le stockage de la valeur globale G;
   - pour chaque source de signaux, un registre de mémoire pour le stockage de la valeur locale L, et
   - des moyens pour obtenir la valeur résultante W grâce à une combinaison prédéterminée de G et L,

   **caractérisé en ce que** le dispositif comporte en outre :

   - des moyens de détection pour déterminer s'il se produit une modification δW de W, induite par une modification du réglage de la commande, dans les limites d'un intervalle de temps prédéterminé ΔT après la sélection d'une source de signaux;

- des moyens aptes à modifier L à raison d'une quantité δL, et G à raison d'une quantité δG, si δW se produit dans les limites de ΔT.

2. Dispositif de traitement de signal suivant la revendication 1, **caractérisé en ce que** δG est pratiquement égale à 0.

3. Dispositif de traitement de signal suivant la revendication 1, **caractérisé en ce que** le dispositif comporte également des moyens pour annuler la modification δG lors de la sélection d'une autre source de signaux.

4. Dispositif de traitement de signal suivant la revendication 1, **caractérisé en ce que** W est pratiquement égale à la somme de L et G.

5. Dispositif de traitement de signal suivant la revendication 1, **caractérisé en ce que** W est pratiquement égale au produit de L et G.

6. Dispositif de traitement de signal suivant la revendication 1, **caractérisé en ce que** lesdites modifications δL et δG sont des fonctions de l'instant auquel la modification δW est induite, en partant du début de ΔT.

7. Dispositif de traitement de signal suivant la revendication 1, **caractérisé en ce que** le dispositif comporte également des moyens pour régler la longueur de l'intervalle de temps ΔT en fonction de conditions prédéterminées régnant avant ou pendant ΔT.

8. Téléviseur incluant un dispositif de traitement de signal à sélecteur de canaux tel que défini dans l'une quelconque des revendications 1 à 7, les moyens de sélection de source de signaux étant un sélecteur de canaux.

9. Procédé de traitement de signaux, comprenant:

- la sélection d'une source de signaux dans un jeu d'au moins deux sources de signaux, le signal provenant de chacune des sources de signaux présentant au moins un paramètre pouvant être commandé, dont la valeur W est définie par une valeur globale G et une valeur locale L associée à une source de signaux sélectionnée;
- le réglage de la valeur W;
- le stockage de la valeur globale G;
- le stockage, pour chaque source de signaux, de la valeur locale associée L;
- la détermination de la valeur résultante W au moyen d'une combinaison prédéterminée de G et L,

**caractérisé en ce que** le procédé comprend en outre :

- la détection de si le réglage de la valeur W se produit dans les limites d'un intervalle de temps prédéterminé AT après la sélection d'une source de signaux, et
- la modification de L d'une quantit δL, et la modification de G d'une quantité δG, si δW se produit dans les limites de ΔT.

10. Procédé suivant la revendication 9, **caractérisé en ce que** δG est pratiquement égale à 0.

11. Procédé suivant la revendication 9, **caractérisé en ce que** la modification δG est annulée lors de la sélection d'une autre source de signaux.

12. Procédé suivant la revendication 9, **caractérisé en ce que** W est pratiquement égale à la somme de L et G.

13. Procédé suivant la revendication 9, **caractérisé en ce que** W est pratiquement égale au produit de L et G.

14. Procédé suivant la revendication 9, **caractérisé en ce que** lesdites modifications δL et δG sont des fonctions de l'instant auquel la modification δW est induite, en partant du début de ΔT.

15. Procédé suivant la revendication 9, **caractérisé en ce que** le procédé comprend également le réglage de la longueur de l'intervalle de temps ΔT en fonction des conditions prédéterminées régnant avant ou pendant ΔT.

16. Procédé suivant l'une quelconque des revendications 9 à 15, **caractérisé en ce que** le procédé comprend la sélection de canaux dans un téléviseur.